# EUROPEAN PATENT APPLICATION

(11) **EP 4 617 683 A1**
(43) Date of publication of application: **17.09.2025**
(21) Application number: 25156821.8
(22) Date of filing: 10.02.2025
(51) Int. Cl.: G01R 19/25, G01R 31/34, G06F 11/34, H02J 13/00

(54) **MOTOR DIAGNOSTICS SYSTEMS AND METHODS**

(30) Priority: 13.03.2024 US 202418603523
(71) Applicant: Schneider Electric USA, Inc., Boston, MA 02108 (US)
(72) Inventor: Bickel, Jon A., Boston, 02108 (US); Menzel, Johannes, Boston, 02108 (US)
(74) Representative: Friese Goeden Patentanwälte PartGmbB

(57) **Abstract**

A causal diagnostic system and method for monitoring and predicting issues associated in an electrical system. A load diagnostic system coupled to a load within the electrical system acquires first data relating to the load and an IED connected within the electrical system nearer an electrical source upstream of the monitored load. The IED acquires second data relating to the electrical system, which is at least one of energy-related data and non-energy-related data. A processor receiving and responsive to the acquired first and second data executes instructions for evaluating the first data against the second data to identify a correlation therebetween, evaluating the identified correlation to determine a condition of the electrical system associated with the IED, and taking at least one action to address the condition of the electrical system associated with the IED.

## Description

### FIELD

The present disclosure relates generally to electrical/power systems, and more particularly, to systems and methods for monitoring and assessing energy-related and non-energy-related data in an electrical system.

### BACKGROUND

Conventional condition-based monitoring (CBM) systems and techniques, especially related to motor diagnostics, focus on motor current signature analysis (MCSA) to analyze and diagnose motor issues. These systems leverage Fourier analysis to evaluate current signatures in the frequency domain, identifying detrimental trends at relevant frequencies. Because MCSA, by definition, focuses on current signature analysis at discrete motor locations, it is difficult to evaluate systemic causes of issues within the electrical system.

Commonly assigned U.S. Patent Application Publication No. 2023/0153389 discloses automatically analyzing electrical waveform data (i.e., waveform captures or WFCs) to identify and reduce extraneous WFCs generated/acquired from an Electrical Power Monitoring System (EPMS), or any related component/element (e.g., an Intelligent Electronic Device (IED)).

Commonly assigned U.S. Patent No. 11,695,427 discloses capturing at least one energy-related waveform using at least one lED in an electrical system.

Monitoring energy-related data in an electrical system as disclosed in commonly assigned U.S. Patent No. 11,740,266 includes processing energy-related data extracted or derived from energy-related signals captured by at least one lED in the electrical system to identify at least one variation/change in the energy-related signals.

### SUMMARY

Aspects of the present disclosure correlate information from at least one CBM system and analyzes the output against data from an electric power management system (EPMS) to identify potential causes of load issues originating at a system level. For example, the cause of motor stator issues can originate with transients, over/undervoltages, voltage unbalances, etc., that in turn originate elsewhere inside or outside an end-user's facility. Embodiments in accordance with the present disclosure help identify systemic causes, which leads to more effective solutions and mitigations. Advantageously, aspects of the present disclosure permit analyzing load diagnostic data (e.g., MCSA) against electrical system data to identify common causes of issues originating within the electrical system, which may simplify and reduce the total cost of mitigating systemic issues and provides useful context-based data and information back and forth between the CBM system and EPMS.

In an aspect, a method for monitoring and predicting issues associated in an electrical system includes acquiring, by at least one load diagnostic system, first data relating to a load within the electrical system monitored by the at least one load diagnostic system. The method also includes acquiring, by at least one IED, second data relating to the electrical system, the second data comprising at least one of energy-related data and non-energy-related data. The at least one lED is electrically connected within the electrical system nearer an electrical source of the system upstream of the load monitored by the at least one load diagnostic system. The method further includes evaluating the first data acquired by the at least one load diagnostic system against the second data acquired by the at least one lED to identify a correlation therebetween, evaluating the identified correlation to determine a condition of the electrical system associated with the at least one IED, and taking at least one action to address the condition of the electrical system associated with the at least one lED.

In another aspect, a causal diagnostic system for monitoring and predicting issues associated in an electrical system comprises at least one load diagnostic system coupled to a load within the electrical system for acquiring first data relating to the load monitored thereby and at least one lED connected within the electrical system nearer an electrical main thereof upstream of the load monitored by the at least one load diagnostic system. The at least one lED acquires second data relating to the electrical system, which is at least one of energy-related data and non-energy-related data. The system further includes at least one processor receiving and responsive to the acquired first and second data and at least one memory device coupled to the at least one processor. The at least one memory device stores processor-executable instructions that, when executed, configure the at least one processor for evaluating the first data acquired by the at least one load diagnostic system against the second data acquired by the at least one lED to identify a correlation therebetween, evaluating the identified correlation to determine a condition of the electrical system associated with the at least one IED, and taking at least one action to address the condition of the electrical system associated with the at least one lED.

Other objects and features of the present invention will be in part apparent and in part pointed out herein.

### BRIEF DESCRIPTION OF THE DRAWINGS

FIG. 1 illustrates an example electrical system in accordance with embodiments of the disclosure.
FIG. 2 illustrates an example electrical single-line diagram with lEDs and CBMs in accordance with embodiments of the disclosure.
FIG. 3 illustrates a system view of an electrical system with lEDs, CBMs and software management elements (e.g., gateways, edge software and cloud-based applications/software) in accordance with embodiments of the disclosure.
FIGS. 4A and 4B is a flow diagram illustrating an example process for assessing motor issues in accordance with embodiments of the disclosure.
FIGS. 5A to 5C are schematic diagrams illustrating example of three-phase systems in accordance with embodiments of the disclosure.

Corresponding reference characters indicate corresponding parts throughout the drawings.

### DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected.

Embodiments in accordance with the present disclosure identify, quantify, troubleshoot, and address issues related primarily to the susceptibilities and influences on three-phase motors in electrical systems. Two important aspects are identifying the source (e.g., upstream or downstream from an intelligent electronic device (IED) or within a system of lEDs) of three-phase electrical system issues and quantifying the impact (e.g., heating, wasted energy, etc.) of such issues on equipment within electrical systems. A general industry rule of thumb is that motors consume more than ten times their original purchase cost in energy costs per year. This means that any motor energy efficiency improvements can add up to substantial savings in operational costs and emissions over time. Moreover, embodiments in accordance with the present disclosure also provide the added benefit of decreasing capital costs by increasing the equipment's life expectancy.

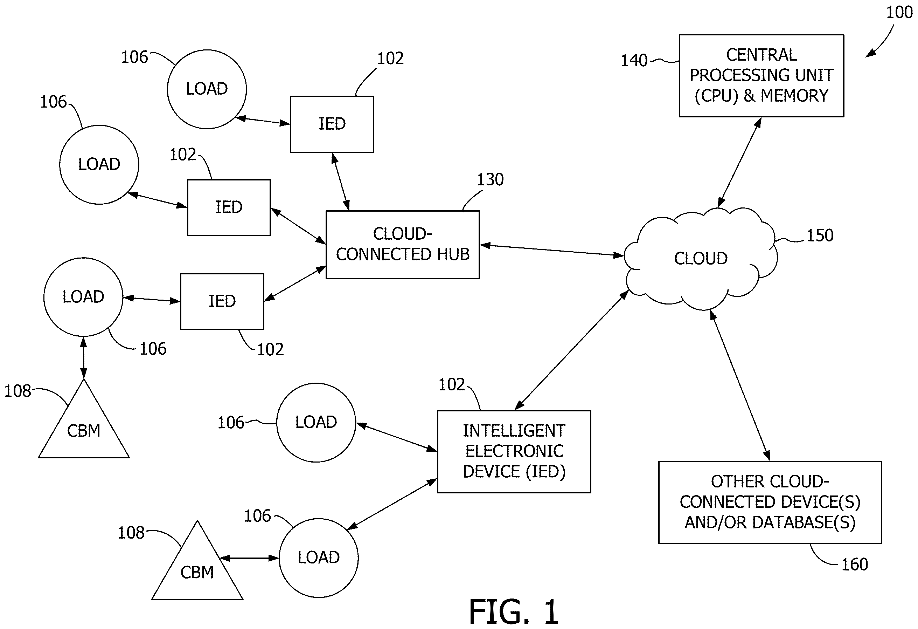

Referring to FIG. 1, an example electrical system 100 in accordance with embodiments of the disclosure includes one or more lEDs 102 capable of sampling, sensing, or monitoring one or more parameters (e.g., power monitoring parameters) associated with one or more loads 106 (also sometimes referred to herein as "equipment" or "apparatuses"). Although indicated with the same reference numeral, it is to be understood that the lEDs 102 may differ from each other (e.g., IEDs with different features and capabilities, etc.) and loads 106 may differ from each other (e.g., motors, lighting, computer servers, etc.) depending on the specific design and features of the electrical system 100. In embodiments, loads 106 and lEDs 102 may be installed in one or more buildings or other physical locations or they may be installed on one or more processes and/or loads within a building or other physical location. The buildings may correspond, for example, to commercial, industrial, governmental, or institutional buildings. Other physical locations, for example, may include oil and gas platforms, parking areas, outdoor areas, or any other relevant area or zone associated with at least one of energy consumption or energy production.

The lEDs 102, as shown in FIG. 1, are each coupled to one or more of the loads 106, which may be located "upline/upstream" or "downline/downstream" from the lEDs in some embodiments. The loads 106 include, for example, machinery or apparatuses associated with a particular application (e.g., an industrial application), applications, and/or process(es) as well as some, all, or nearly all of the machinery, etc. inside or outside a facility. The machinery may include electrical or electronic equipment, for example. The machinery may also include the controls and/or ancillary equipment associated with the equipment. In accordance with aspects of the present disclosure, loads 106 comprise a mix of single-phase, phase-to-phase, and three-phase loads (e.g., motors), or any relevant electrical configuration required to operate equipment associated with an end-user's system or facility.

In one or more embodiments, lEDs 102 may monitor and, in some embodiments, analyze parameters (e.g., energy-related parameters) associated with loads 106 to which they are coupled. For instance, lED 102 (e.g., a metering device) captures energy-related waveforms in electrical system 100. As used herein, an lED is a computational electronic device optimized to perform a particular function or set of functions. Examples of lEDs 102 include smart utility meters, power quality meters, microprocessor relays, digital fault recorders, and other metering devices. The lEDs 102 may also be embedded in variable speed drives (VSDs), protection equipment, programmable logic controllers (PLCs), uninterruptible power supplies (UPSs), circuit breakers, relays, transformers, or any other electrical apparatus. In addition, lEDs 102 may be used to perform measurement/monitoring and control functions in a wide variety of installations. The installations may include utility systems, industrial facilities, warehouses, office buildings or other commercial complexes, campus facilities, computing co-location centers, data centers, power distribution networks, or any other structure, process or load that uses electrical energy. For example, where lED 102 is an electrical power monitoring device, it may be coupled to (or be installed in) an electrical power transmission or distribution system and configured to sense/measure and store data (e.g., waveform data, logged data, I/O data, etc.) as electrical parameters representing operating characteristics (e.g., voltage, current, waveform distortion, power, etc.) of the electrical distribution system. These parameters and characteristics may be analyzed by a user to evaluate potential performance, reliability and/or power quality-related issues, for example. One or more of the lEDs 102 may include at least a controller (which in certain lEDs can be configured to run one or more applications simultaneously, serially, or both), firmware, a memory, a communications interface, and connectors that connect the lED to external systems, devices, and/or components at any voltage level, configuration, and/or type (e.g., AC, DC). At least certain aspects of the monitoring and control functionality of lED 102 may be embodied in a computer program that is accessible by the lED (e.g., PLC data, etc.).

The term "IED" as used herein may refer to a plurality and hierarchy of IEDs operating in parallel and/or tandem (series). For example, an IED may correspond to an aspect of a hierarchy of energy meters, power meters, and/or other types of resource meters. The hierarchy may comprise a tree-based hierarchy, such a binary tree, a tree having one or more child nodes descending from each parent node or nodes, or combinations thereof, wherein each node represents a specific lED. In some instances, the hierarchy of IEDs may share data or hardware resources and may execute shared software. It is understood that hierarchies may be non-spatial such as billing hierarchies where IEDs grouped together may be physically unrelated.

According to another aspect, lEDs 102 may detect overvoltage and undervoltage conditions (e.g., transient overvoltages), as well as other parameters such as temperature, including ambient temperature. According to a further aspect, lEDs 102 may provide indications of monitored parameters and detected conditions that can be used to control loads 106 and other equipment in the electrical system 100 in which loads 106 and lEDs 102 are installed. A wide variety of other monitoring and/or control functions can be performed by lEDs 102 and the aspects and embodiments disclosed herein are not limited to lEDs 102 operating as described in the above-mentioned examples.

It is to be understood that lEDs 102 may take various forms and may each have an associated complexity (or set of functional capabilities and/or features). For example, one lED 102 is a "basic" lED while another lED 102 is an "intermediate" lED and yet another lED 102 is an "advanced" lED. In such embodiments, the intermediate lED may have more functionality (e.g., energy measurement features and/or capabilities) than the basic IED, and advanced lED may have more functionality and/or features than both the intermediate lED and the basic lED. For example, in embodiments lED 102 (e.g., an lED with basic capabilities and/or features) may be capable of monitoring instantaneous voltage, current energy, demand, power factor, averages values, maximum values, instantaneous power, and/or long-duration rms variations and/or lED 102 (e.g., an lED with advanced capabilities) may be capable of monitoring additional parameters such as voltage transients, voltage fluctuations, frequency slew rates, harmonic power flows, and discrete harmonic components, all at higher sample rates, etc. It is understood that this example is for illustrative purposes only, and likewise in some embodiments an lED with basic capabilities may be capable of monitoring one or more of the above energy measurement parameters that are indicated as being associated with an lED with advanced capabilities. It is also understood that in some embodiments the lEDs 102 each have independent functionality.

Referring further to FIG. 1, one or more loads 106 may be monitored by a load diagnostic system, such as a condition-based monitoring (CBM) system 108. Condition-based monitoring allows a user to extract data relating to one or more of vibration, acoustics, temperature, current, voltage, etc. to assist in answering critical questions about the condition of the monitored load 106. Such condition-based monitoring of loads 106 may help the user transition from reactive maintenance approach to proactive maintenance approach by highlighting potential problems and notifying systems of abnormal behavior in advance of failure. Motor current signature analysis (MCSA) for condition-based monitoring has some advantages over conventional vibration, acoustic, and thermal monitoring techniques. MCSA measures minor fluctuations in both the current draw and supply voltage of the power lines feeding a motor or other rotating equipment. These electrical "signatures" may provide early indications of imminent failures with increased sensitivity and accuracy over other methods. The technology can diagnose specific failure modes or their original causes, whether they are mechanical or electrical. Although indicated with the same reference numeral, it is to be understood that the CBM systems 108 may differ from each other depending on the specific design, features, loads, and/or requirements of the electrical system 100. It should be understood that MCSA is used as an example of a CBM that performs electrical signal analysis, and is not limited to current signature analysis only. Analyses may be performed on at least one direct measurement (e.g., voltage, current, vibration, temperature, etc.) or one inferred/derived/calculated parameter (e.g., power, power factor, waveform distortion, etc.).

MCSA for condition-based monitoring, for instance, allows prediction of both known and unknown failure patterns and global "wear and tear" estimations, while providing a longer lead time in failure prediction. This provides a maintenance team with more time to order spare parts and schedule repairs while minimizing the impact to operations. In addition, MCSA failure analysis can also give clues to electrical conditions that are occurring upstream of load 106 (e.g., power quality anomalies) that may be causing a particular issue.

In the example embodiment of FIG. 1, lEDs 102 are communicatively coupled to a central processing unit (CPU) 140 (and associated memory) via a data communications network shown as "cloud" 150. In some embodiments, lEDs 102 may be directly communicatively coupled to the cloud 150. In other embodiments, lEDs 102 may be indirectly communicatively coupled to cloud 150 via, for example, an intermediate device such as a cloud-connected hub 130 (or a gateway) providing lEDs 102 with access to cloud 150 and CPU 140 or edge software in lieu of or in conjunction with gateway/hub 130.

Commonly assigned U.S. Patent Application Publication No. 2023/0152833 discloses a cloud-connected electrical system in which aspects of the present disclosure may be used.

Although illustrated locally in connection with an associated load 106, it is to understood that a CBM system 108 may be implemented in a distributed manner. One advantage of MCSA is the ability to upload data to cloud 150 using, for example, cellular communications. MCSA may be uploaded to a central, cloud-based asset management system, such as CPU 140, which can include the support of expert services. A set of machine learning algorithms first makes a model of "initial normal" motor behavior with an associated normal motor current signature. If a motor operating behavior begins to drift out of the normal operating range, anomalies are detected and classified through recognized variations in the motor current signature. These sensing technologies and analytical methods can be used to detect and diagnose a broad range of potential failure modes including stator shorts, bearing degradation, loose rotor bars, coupling misalignment, mechanical or electrical imbalance, general aging, and more.

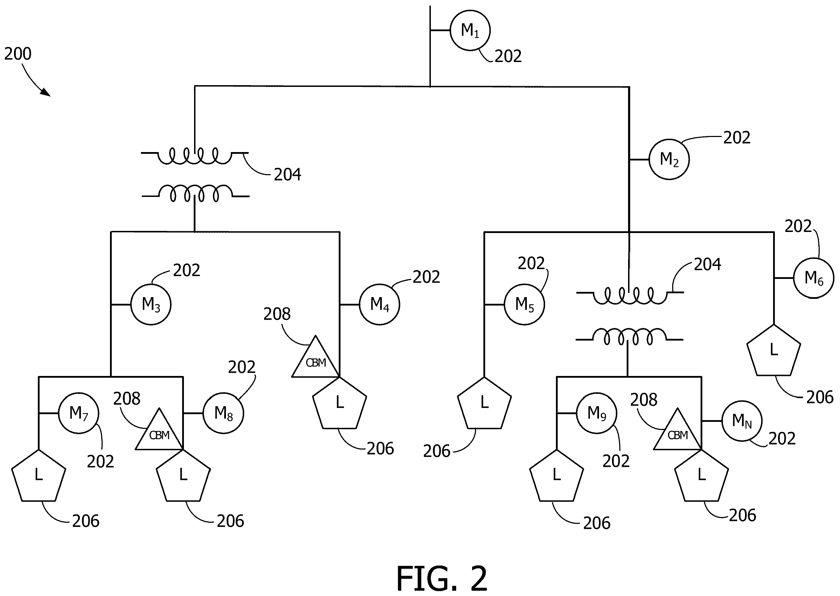

FIG. 2 illustrates an example electrical system 200 for which aspects of the present disclosure may be used to identify potential causes originating at a system level. In particular, FIG. 2 shows an exemplary electrical single line diagram that includes components of an electrical power monitoring system (EPMS) (i.e., IEDs/metering devices) in accordance with embodiments of this disclosure for capturing, analyzing, and compressing data (e.g., energy-related waveforms). As shown in FIG. 2, the EPMS often incorporates a diverse array of lEDs, illustrated as a plurality of meters 202, that are installed throughout electrical system 200 for monitoring a mix of single-phase and three-phase downstream loads 206. The meters 202 (or lEDs) may have different levels of capabilities and feature sets; some more and some less. For example, energy consumers often install high-end (best/most capabilities) lEDs at the location where electrical energy enters their premises (i.e., M1 in FIG. 2). This is done to acquire the broadest understanding possible of the electrical signals' quality and characteristics as received from the source (typically, the utility). Because the budget for metering is usually fixed and the energy consumer often needs to meter as broadly as possible across the electrical system, conventional wisdom stipulates using lEDs with progressively lower costs as the installed meter points get closer to the loads (with some exceptions). With this in mind, many facilities incorporate more low/mid-range lEDs than high-end lEDs. FIG. 2 further illustrates system 200 with two step-down transformers 204 as well as a number of CBM systems 208 each associated with one of the loads 206. It is to be understood that the electrical system 200 of FIG. 2 is just one embodiment of a myriad of potential embodiments to teach the concepts described herein.

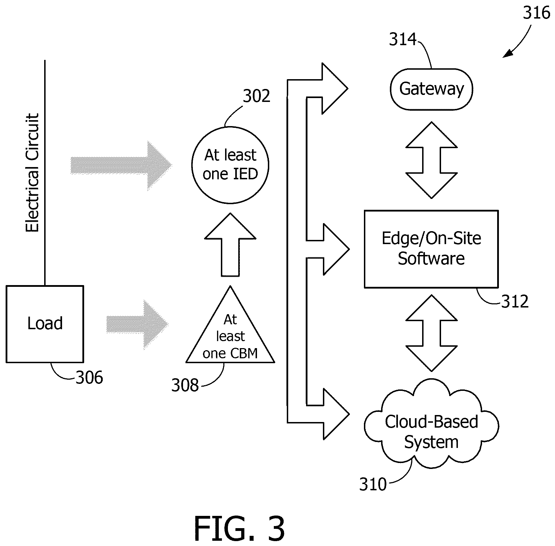

Referring now to FIG. 3 aspects of the present disclosure aggregate information from two or more data sources associated with a load 306 to identify potential issues originating at a system level. In the illustrated embodiment, the data sources comprise at least one CBM system 308 (e.g., CBM system 108 or 208) and at least one lED 302 (e.g., lED 102 or meter 202), which is a component of the EPMS. In an alternative embodiment, the data sources comprise two or more CBM systems 308 in addition to the EPMS. For example, the cause of motor stator issues can originate with transients, over/undervoltages, voltage unbalances, etc., that in turn originate elsewhere inside or outside an end-user's facility. Embodiments in accordance with the present disclosure help identify systemic causes, which leads to more effective solutions and mitigations. Advantageously, aspects of the present disclosure permit analyzing load diagnostic data (e.g., MCSA) against electrical system data to identify common causes of issues originating within the electrical system, which simplifies and reduces the total cost of mitigating systemic issues and provides useful context-based data and information back and forth between the CBM system and EPMS.

In some embodiments, the MCSA data provided by the at least one CBM system 308 and the energy-related data from or derived from the energy-related signals captured by the at least one lED 302 are processed on at least one of: the at least one lED 302, a cloud-based system 310, edge or on-site software 312, or a gateway 314 (e.g., hub 130) (which may be referred to alternatively or collectively herein as a "head-end" system 316). One or more of these elements (310, 312, 314) make up the software management aspect of the head-end system 316, and may be capable of performing at least one of managing applications, monitoring, optimizing, observing, processing, analyzing, hosting, storing, facilitating, aggregating, logging, searching, and/or virtualizing. Databases may also be managed by at least one of these software management elements, accordingly. Additionally, analytics (e.g., artificial intelligence, machine learning, statistical processing, etc.) may be fully or partially performed on any one or more of these elements, and one or more outputs from these analytics may be provided fully or partially to any other element within the system (302, 306, 308, 310, 312, 314, or other) as required.

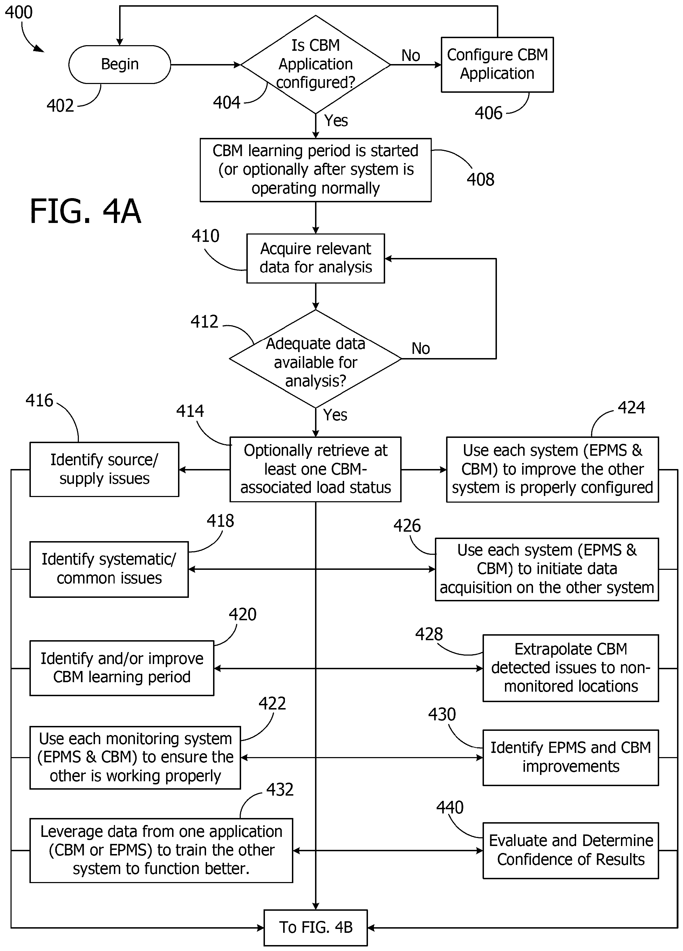

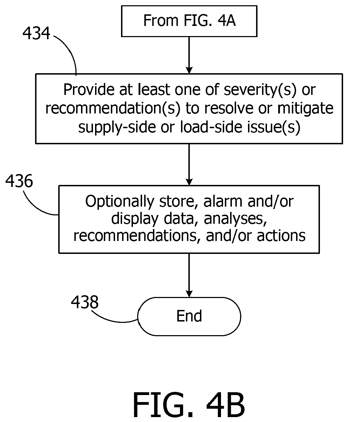

FIGS. 4A and 4B illustrate an example process 400 embodying aspects of the present disclosure, which permits analysis of data acquired from a plurality of CBM systems 108, 208 to identify system level potential causes of issues within an electrical system, such as electrical system 100 or electrical system 200.

The process 400 begins at 402 and evaluates at 404 whether the EPMS and CBM system(s) have been properly configured for this application. Different evaluations may be performed on various aspects of the EPMS and CBM(s), which may include: device type(s), signal sample rate(s), load type(s), customer type(s), process type(s), alarm setting(s), logging interval(s), load(s) metadata (e.g., motor nameplate data, etc.), EPMS metadata, process(es), location(s), temporal context (e.g., timestamps, synchronization, etc.), and so forth. In the event that one or more aspects of the EPMS and/or at least one CBM have not been adequately and/or properly configured, an indication may be provided to the end-user to address the issue, or alternatively, an embodiment in accordance with the present disclosure may automatically configure or resolve the issue itself at 406 before returning to 402. Optionally, aspects of the present disclosure include reevaluating the configuration to ensure there are no longer any configuration issues with the application. Further it may be noted that the EPMS may evolve over time to reflect the changes to the electrical installation (e.g. electrical renovation, adding to the building or changing the processes and appliances used in the site, adding more meters into the EPMS, etc.). When changes are made, the configuration of both systems may be updated to reflect the known changes. This will help diagnose correlated systemic events and will also enable discriminating these correlated and systemic issues from non-correlated issues (e.g., installing another load elsewhere in the EPMS, installing another IED, changing the location of a load in the site/electrical installation, etc.).

Correlation may be considered in a narrow sense (i.e., statistically). For example, recurrent or continuous event(s)/issue(s) may be systematically detected/identified at the EPMS and at least one associated CBM system. In this case, calculating correlation will identify a high statistical correlation value between the EPMS and the at least one associated CBM system. If at least a second associated CBM system does not systematically detect/identify the recurrent or continuous event(s)/issue(s), the statistical correlation value will be lower than for the first at least one associated CBM system.

In a broader sense, correlation may refer to the identification and/or characterization of a relationship between issues, events, measurements, locations, systems, lED types, segments, and so forth. This relationship may be based on any number of factors or approaches, including: calculations, knowledge, recommendations, insights, new data, metadata, observation, new analyses, new systems (e.g., additional CBM system, etc.), and so forth.

Once the configuration of the application, EPMS, and CBM has been addressed, a CBM learning period may be started at 408. In an alternative embodiment, the CBM learning period at 408 begins prior to completing configuration at 406. The purpose of the CBM learning period is to baseline the targeted load's operation. The CBM acquires relevant data for analysis at 410. In the instance, the CBM may evaluate various parameters (e.g., currents, voltages, temperatures, displacements, velocities, accelerations, frequencies/frequency spectrums, pressures, speed, associated metadata, etc.) to develop a reference level. Additionally, thresholds may be established once the typical parameter range(s) have been determined/ascertained.

In an embodiment, parameter data may be continuously evaluated to identify relevant variations, excursions, and/or trends that may signify anomalous or degrading conditions. Statistical methods and/or trends may be used to identify, categorize, and/or distinguish the relevancy of any one or more variations, excursions, change points, and/or trends. Parameter data may be analyzed, assessed, graphed, stored, alarmed upon, etc. as required, configured, or requested. Having relevant parameter data (and/or optionally, a valid equipment model) to assess is an important part of this application. Depending on the parameter to be analyzed or the assessment to be performed, some minimum number of parameter data points may be required. If statistical analyses or assessments are to be performed, there may be a required number of parameter data points to generate a statistically relevant result. The logging/sample intervals from the CBM and EPMS systems may or may not be relevant, depending on what potential issue is being analyzed. For example, parameters such as harmonic distortion or unbalance are both considered to be "steady-state" phenomena; therefore, a general approximation of the respective data's occurrence may be acceptable. With that being the case, it may be important that the load(s)/motor(s) actually be operating so that data is available for comparison and/or analysis.

In some cases, two or more parameters may be required for a specific type of analysis or assessment. For example, currents and voltages from each of the three phases may be useful to identify, evaluate and quantify the severity of unbalance conditions and respective sources (i.e., system or motor). Assuming adequate data is available for analysis, as determined at 412, the learning period concludes. If adequate data is not available, as determined at 412, the learning period continues and/or more relevant data is obtained. If the two or more systems (e.g., one EPMS system with several CBM systems) are implement or connected at different times/dates, the learning period may be restarted or updated to leverage the mutual analysis/information extracted from each system. This could help both systems discriminate between systemic issues originating at the motor and systemic issues originating elsewhere in the installation (as identified from the EPMS system/analysis).

Referring further to FIG. 4A, the process 400 continues at 414. Once data (e.g., measured, metadata, etc.) and/or information is available for analysis, it may be useful to ascertain the operational status/condition of a CBM-associated motor load(s). For example, a de-energized motor will not be able to provide relevant/useful information in most cases; however, automatically (e.g., using algorithms, etc.), manually (e.g., human intervention, etc.), or through some external input (e.g., using I/O, etc.) determining the operational status of one or more motors would allow this invention's algorithms to more precisely identify and evaluate issues associated with systemic causes versus isolated (discrete) motor problems.

The example process 400 of FIGS. 4A and 4B performs one or more sub-processes at 416 to 432. At 416, there are a variety of electrical issues in motors being evaluated by CBMs. For example, transient overvoltages can cause motor winding insulation to fail, voltage sags can stress motors (depending on the voltage sag's characteristics, voltage sags can (in some cases) produce motor contactor bouncing that causes transient events (leading to the aforementioned problem with transient overvoltages), steady-state unbalance and harmonic distortion can lead to the overheating of motors and degradation of its winding insulation, steady-state overvoltage and undervoltage conditions can also produce overheating of motors and degrade winding insulation, just to name a few. An excessive amount of any one or more of these issues may lead to motor stress and a premature failure of the motor.

This feature at 416 correlates issues identified by one or more CBMs with the more systemic issues identified by EPMSs. For example, transient overvoltages may lead to a short between windings (e.g., turn-to-turn, phase-to-ground short). While the origin of the transient voltage may be external/upstream from the motor load, the effect (e.g., turn-to-turn, phase-to-ground short) occurs inside the motor. The CBM will identify this short and provide a notification to the end-user accordingly, agnostic that the origin of the short's source is external to the motor. However, a capable EPMS that is properly configured may determine the existence of one or more transient overvoltage events that led to the short in the motor.

The CBM system's database may contain information associated with an identified or potential motor load(s) issues. It may also contain information that has either not been analyzed or an issue determination has not yet been made. In the event at least one or more identified or potential issues are indicated by the CBM system, timestamps associated with the relevant data can be assessed to determine correlations with systemic issues from either the EPMS or other CBM-based system on the same electrical system. At 418, it is possible that systemic conditions such as overvoltage, undervoltage, harmonic distortion, unbalance, sags, swells, etc. can cause motor issues (see step 416 above). Again, correlating the data from EPMSs with the data from CBMs can help identify potential systemic issues. An important part of this feature's evaluation is when two or more CBMs are being applied. Aggregating and jointly assessing EPMS data and CBM data from multiple points can help determine the presence of a systemic issue, especially if the discrete issues from CBM-based systems relate or correlate with each other. An example may be excessive heating in multiple motors leading to frequent motor failures. An evaluation of the data may indicate a common (systemic) voltage unbalance condition is an important factor in these failures.

Referring now to step 420 of FIG. 4A, CBM systems often employ a "learning period" to establish a baseline of "what's normal" before they begin to actually monitor and evaluate operational parameters for motors to determine "what's abnormal and potentially impacting." There are a few potential complications with this approach including: 1) determining how long the learning period should be, 2) the occurrence of some external electrical perturbation or variance during the learning period (unbeknownst to the CBM system), and 3) a preexistent issue with the load being baselined. Any of these problems may affect the quality of the data during the learning period, thus, skewing the determination of "what is normal." The outcome may be disregarded or latent relevant information provided by the CBM system(s) regarding the health of the load/motor under consideration.

To reduce this risk, data from the EPMS may be used in conjunction to identify external electrical issues that can skew baseline data accumulated during the learning period. For example, when a condition that may skew the CBM system's baseline data is detected by the EPMS, this feature either restarts the learning period, expunges the affected data used to create the CBM system's baseline, or provides an indication to the end-user that such an event has occurred and/or should be considered/reevaluated. In future versions of the CBM system(s), the input may be stored and characterized (e.g., defining a signature from a database or library) to discriminate between discrete load related issues and systemic EPMS system-related issues.

At 422, this aspect of the present disclosure leverages multiple (two or more) applications (e.g., EPMS, CBM) evaluating data from the same electrical system. When one application identifies an issue that should or could have been identified by the at least one other applications, an action is taken. For example, one action may be to notify the end-user (e.g., alarm, email, etc.) that at least one (and optionally, which one) of the applications does not appear to be performing properly and that a remedial action should be taken. Another action that may be taken could be to evaluate the application that does not appear to be performing properly and identifying potential misconfigurations (e.g., misconfigured alarm threshold, etc.) or any other issue with the application. If two or more applications (e.g., discrete CBMs, etc.) identify a similar/related issue that should have likely also been identified by a third or more applications (e.g., EPMS, CBM, etc.), the probability of an issue existing with the third or more application is higher and the priority of resolving the discrepancy may be greater. Any attempts (successful or unsuccessful) to resolve the issue with the third or more applications may be stored for future assessments or for historical purposes.

At 424, a monitoring system is used to ensure others are properly configured - As part of step 422 above, CBM and EPMS settings are evaluated to ensure each is properly set up (with or without any application issue(s)). Because at least two applications (e.g., EPMS, CBM(s)) are working collectively in the disclosed embodiments, it is important that they be configured as such. For example, a cloud-based application may be able to upload and evaluate the configuration settings, capabilities/features, historical information, and/or other meta data associated with each connected application (e.g., EPMS, CBM, etc.). Any issues, discrepancies, opportunities and/or other improvements may be identified from a system perspective (e.g., in the cloud, edge software, etc.), and an action may be taken to remedy or enhance the system (e.g., EPMS, CBM, etc.) performance accordingly. In some cases, the end-user may be notified a part or entirety of the application(s) should be reconfigured to better optimize its performance and results. This multi-system analysis and/or configuration optimization may also be performed by specialized services engineers relying on the principles and methods described in the present application and using the data and knowledge from both systems. In addition, at 424, the process 400 may also provide measurement capabilities or calculated/inferred features of one system to another system, if the other system has more limited capabilities.

When an issue (or potential/impending issue) is discovered where the at least one CBM is operating independently from the EPMS or other CBMs, the process 400 indicates at 426 (through some communicative means) the need to increase the sample rate, logging interval, and/or any other technique to capture more/better relevant information to assess, troubleshoot and/or resolve or mitigate the issue. Additionally, at least one alarm threshold may be decreased to ensure relevant or useful data may be captured related to the said issue (or potential/impending issue).

For example, a CBM may indicate an issue (or potential/impending issue) has, is, may or will occur through some communicative means to a second or more relevant systems. After receiving said indication of an issue, the second or more relevant system may take some action to improve the quality of data acquired from devices with which it is associated. The second or more relevant system may be an EPMS that has, for example, several lEDs communicatively coupled to it. The original indication from the CBM (and communicated to at least one aspect of the EPMS) may result in the EPMS changing the sample rate or logging interval of one or more relevant lEDs to ensure extensive and relevant data (including waveform captures) is measured and/or captured related to the issue. This extensive and relevant data may be used to validate that an issue does indeed exist, to improve troubleshooting, to evaluate impact to other areas of the electrical system, to provide more extensive mitigation assessments and opportunities, and so forth.

At 428, CBM applications are generally discrete, meaning that one CBM (e.g., vibration sensor) monitors one load or load acquisition point. In the case of motor diagnostics, a single CBM device will monitor a single motor. Due to their expense, end-users may opt to install CBMs on a subset of their systems, processes, or loads. If/when this is the case, it may be possible to infer issues, potential issues, susceptibilities, and/or important trends in areas and on loads where no CBMs have been directly connected.

For example, a CBM monitoring a motor load may detect interharmonic current frequencies that indicate a potential broken rotor bar in the motor. An lED connected to an EPMS and located upstream from the motor's CBM may also measure these interharmonic current frequencies along with supplemental interharmonic current frequencies unrelated/not detected by those that are detected by the CBM. In this case, it is possible to "remove" the measured current frequency values detected (which include the interharmonic current frequencies) by the motor's CBM from the measured current frequency values detected (also including the interharmonic frequencies) by the lED connected to the EPMS to quantify the residual current frequency values (including the residual interharmonic frequency values). The residual interharmonic current frequencies may then be assessed/analyzed to identify potential issues associated with other loads downstream from the IED, excluding the measured current frequencies from the motor's CBM. While this approach may not provide a specific indication regarding a particular downstream load issue, it may provide a clue to which downstream load has an issue. Alternatively, it may also provide a general indication of a downstream issue that needs to be addressed. If this is the case, the invention may provide recommendations for additional monitoring (i.e., lEDs or CBMs) as needed. It should be noted that harmonic and interharmonic power flow directions may be determined using the voltage and current magnitudes and phase angles at discrete harmonic and interharmonic frequencies. Using this determination on the residual interharmonic frequencies would indicate whether the source of the residual interharmonic frequencies is upstream or downstream from the lED's connected point on the electrical system. It should also be noted that from an upstream lED point, it may be possible to determine two or more loads switching on/off at different times, and to identify which of these load(s) are generating harmonic or interharmonic currents.

Referring now to 430, the example process 400 of FIGS. 4A and 4B, such as indicated at steps 422, 424, and 428 above, may be used to identify potential system improvements. These recommendations may be initiated by issues as indicated from measured data, metadata, analyses outputs, or by some other means. For example, metadata may indicate several large (e.g., 500 H.P.) motors installed within the end-user's electrical system; however, only one motor CBM is employed. Because large motors are expensive to purchase, operate, and have a bigger impact when experiencing poor efficiency, it may be prudent to purchase and install motor CBMs, accordingly. In this case, perhaps only two of the multitude of these motors operates regularly. In this case, the process embodying aspects of the present disclosure may help prioritize (based on some criteria such as run hours) recommendations for additional CBMs. Similarly, it may be prudent to install supplemental lEDs to the EPMS to help evaluate or provide redundancy for the distributed CBMs. It should be noted that motor start characteristics (e.g., inrush current magnitudes and shapes, steady-state current magnitudes, voltage characteristics, affected phases, synchronicity of events across phases, reactive power and energy characteristics, etc.) may be used to approximately determine and/or size a motor application by an lED connected upstream, which may be useful for this aspect of the invention.

At 432, another interesting use of this algorithm is to leverage data from CBMs for correlation with data from an EPMS, leading to beneficial improvements for both the CBM and EPMS (and associated IED) algorithms. For example, a CBM application may be used to evaluate a motor's condition over time for the purpose of identifying the motor bearing issue, which ultimately experiences a failure. The CBM data is then partially or fully imported into a database that also contains one or more data sets from one or more lEDs that were captured during the same period that the CBM data was captured. Even though the EPMS (and/or its associated IED(s) may not employ the same targeted and/or sophisticated algorithms as those employed by the CBM, the characteristics of the CBM data (that include the trend and eventual failure of the motor) may be leveraged to train and/or identify seemingly innocuous trends in the EPMS (and associated IEDs) data, which also indicate the eventual failure. This type of enriched data may be helpful to EPMS system end-users for discriminating the causes of alarms between two or more of the systems (e.g., EPMS, CBM1, CBM2). This information may also be used to train the algorithms (e.g., machine learning, etc.) to identify potential issues in non-monitored systems, processes and loads. In addition, as shown at 440, aspects of the present disclosure further evaluate the data for assessing a confidence level of the results.

Because each electrical system and its loads are unique, there are nuanced limitations or particular constraints associated with how a system or algorithm responds to distinct event(s). For example, it is possible that one algorithm may perform better under certain conditions than another. Evaluating an event or issues from various locations dispersed at different points within the electrical system is useful for many reasons, including: 1) it helps to locate the issue's source, 2) it helps to quantify the severity of the issue, and 3) it provides redundant assessments of the event or issue from different "points-of-view."

This third reason is important because it improves the level of confidence in the results and/or determinations by the algorithms. For example, the CBM system may be evaluating motor current signatures, which indicate a broken rotor bar. Similarly, an EPMS's lED upstream from the motor load may also indicate the presence of a broken rotor bar downstream from its location. Having both the CBM system and the lED (two independent systems) provide comparable results provides a more persuasive conclusion that the motor's rotor bar is indeed cracked or broken.

Determining the "level of confidence" may be performed in many ways. For example, a simple statistical approach may be to evaluate the results from each independent system (e.g., CBM, IED, etc.) and combine them accordingly. In the example above, two independent systems concur that a broken rotor bar exists downstream from the lED and on the motor being evaluated by the CBM. These two results are both congruent with each other, so the level of confidence is higher than just relying on the results from a single system (e.g., CBM). It is also possible to weight a first system (e.g., CBM) more heavily than a second system (e.g., EPMS), for example. In one implementation, the first system may be considered to be more valid or applicable by experts in the field. As such, the first system may be more heavily weighted by experts during configuration/setup or during their analysis(es)/assessments. In another implementation, consider a first system (e.g., CBM) that is twice as likely to be correct than the second system (e.g., EPMS). In the event the results from both systems are dissimilar, the first system's (e.g., CBM) conclusion would be used because it has a higher probability of being correct than the second system. There are many statistical and mathematical methods and techniques for combining the outcomes from different systems, which someone with ordinary skill in the art may understand or consider.

Proceeding to step 434 of FIG. 4B, after any one or more assessment/analysis has been performed from the applications/ideas described above, it is possible to provide at least one recommendation(s) to identify, prioritize, resolve and/or mitigate the issues(s). The recommendation and or outcome of these applications/ideas may include at least one of: an issues location, an issues prevalence, severity, potential impact, required mitigation equipment, validation or verification of issues and/or solutions, confidence indicator, and so forth. In accordance with some embodiments of this disclosure, the at least one recommendation action is selected based on at least one of a variety of factors including, for example, cost, availability, time to implement, safety improvement(s), whether the solution(s) is/are hardware or software based, etc. At least one action may be taken or performed in response to the at least one provided recommendation action by at least one of an EPMS system and/or a CBM system. For example, in embodiment in which the at least one lED responsible for capturing the energy-related signals is part of an EPMS, the EPMS may control one or more aspects of the electrical system (i.e., an example at least one action) in response to the at least one provided recommendation action.

At 436, a final step in the disclosed process 400 is the prioritization and management of its outcome/output. Data, issues, recommendations, assessments, improvements, results, impacts/affects, and so forth may optionally be stored, alarmed upon, displayed, analyzed/assessed, removed, deleted, edited, highlighted, and/or acted upon in any other way. Regardless of the action, the outcome/output will be formatted and/or provided in such a way that is useful and/or relevant to the end-user. At 436, which is optional in some embodiments, one or more types of relevant information may be stored, for example, for future use and/or analysis. For example, information collected in any of the steps of process 400 (e.g., characteristic(s) related to the event, impact, recovery metric(s), action(s) taken, and/or status(es) related to analysis of impact characteristic(s), recommendation(s) to address, improve and/or optimize recovery, etc.) may be stored. This may be used to train existing or ancillary (e.g., other) systems on new issues, for example, supervised learning or reinforced learning by providing the validated data. It may also be used to re-train these systems by adding this data to the training data, for example, adding this as measurements, metadata, and/or as validated diagnostic. For example, analyzing load diagnostic data (e.g., MCSA) against electrical system data to identify common causes of issues originating within the electrical system at 436 can simplify and reduce the total cost of mitigating systemic issues as well as provide useful context-based data and information back and forth between the CBM system and EPMS.

In embodiments in which relevant information is stored, it is understood that the relevant information may be stored locally (e.g., on at least one local storage device) and/or remotely (e.g., on cloud-based storage), for example, based on a user-configured preference. For example, a user may indicate their preference to store the relevant information locally and/or remotely in a user interface (e.g., of a user device), and the relevant information may be stored based on the user-configured preference. It is understood that the location(s) in which the relevant information is stored may be based on a variety of other factors including customer type(s)/segment(s), process(es), memory requirements, cost(s), system (e.g., EPMS, CBM), etc.

It is also understood that the relevant information may be stored during any step of process 400 illustrated in FIGS. 4A and 4B. In other words, step 436 does not necessarily need to occur after block 434 as shown in FIGS. 4A and 4B. Rather, it may occur at one or more points during process 400.

After taking these steps, the example process of FIGS. 4A and 4B ends at 438. Of course, the invention may be operated, in part or in whole, once, intermittently, randomly, regularly or continuously.

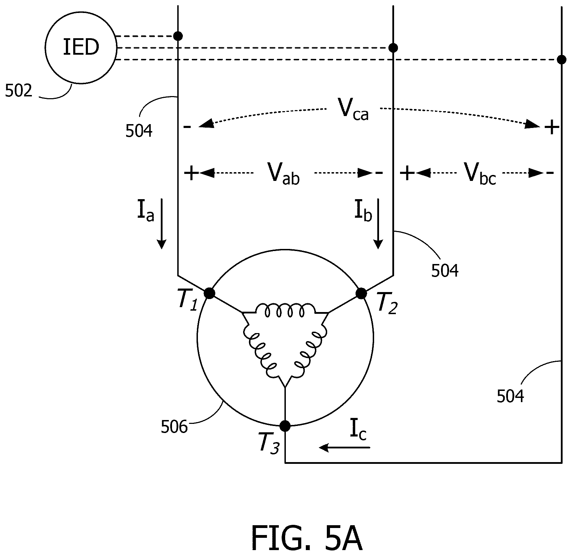

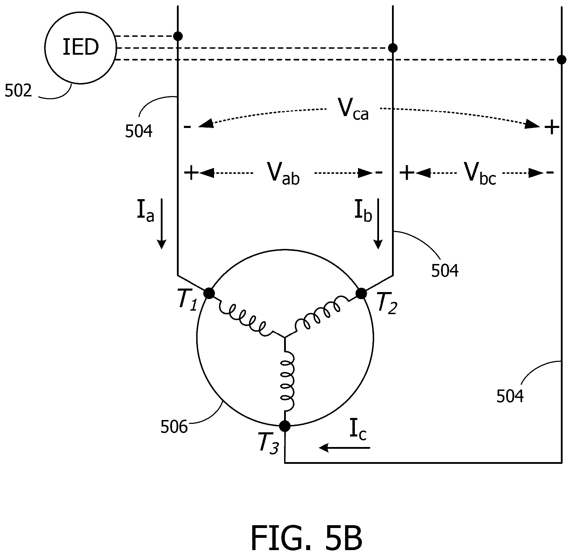

FIGS. 5A to 5C are informative of acquisition of the individual parameters to be analyzed (e.g., three-phase current, three-phase apparent power, three-phase real power, etc.). FIG. 5A illustrates an example of a simple three-phase application. As shown in FIG. 5A, an lED 502 (e.g., lED 102 of FIG. 1, meter 202 of FIG. 2, lED 302 of FIG. 3) acquires electrical signals, data, and information from three conductors 504 serving a three-phase delta wound motor load 506. It is to be understood that acquiring data as described herein may include acquisition, measurement, capture, logging, etc. Similarly, FIG. 5B illustrates the lED 502 acquiring electrical data and information from the three conductors 504 feeding a three-phase wye wound motor load 506.

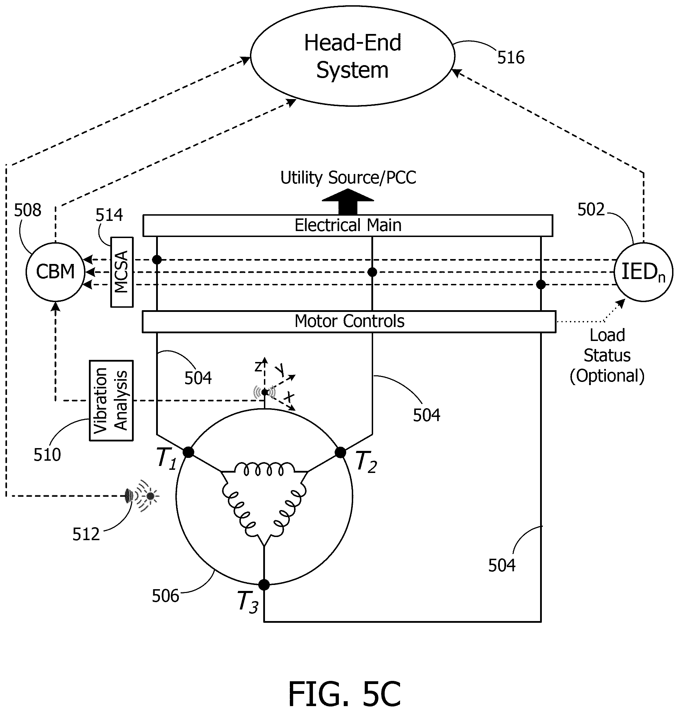

FIG. 5C illustrates further aspects of an example of a simple three-phase application in accordance with one or more embodiments of the present disclosure. In FIG. 5C, for use with the lED 502 acquires electrical data and information from three conductors 504 feeding a three-phase delta wound motor load 506. In addition, a CBM system 508 (e.g., CBM 108 of FIG. 1, CBM 208 of FIG. 2, CBM 308 of FIG. 3) monitors load 506 based on one or more of vibration 510, acoustic 512, thermal (not shown), and MCSA 514 monitoring techniques. A head-end system 516, such as the head-end system 316 of FIG. 3 including the cloud-based system 310, and/or on-site or edge software 312, and/or the gateway 314, processes the data provided by the at least one CBM system 508 and data from or derived from the energy-related signals captured by the at least one lED 502. After the head-end system 516 performs any one or more assessment/analysis from the applications/ideas described above (see FIG. 4A), it is possible to provide at least one recommendation(s) to identify, prioritize, resolve and/or mitigate the issues(s). The recommendation and or outcome of these applications/ideas may include at least one of: an issues location, an issues prevalence, severity, potential impact, trend, required mitigation equipment, validation or verification of issues and/or solutions, confidence level, and so forth.

In an embodiment, a method for monitoring and predicting issues associated with loads in an electrical system includes collecting at least one of energy-related data and non-energy-related data (or metadata) from at least one load diagnostic system (e.g., CBM system or application) within the electrical system and collecting at least one of energy-related data and non-energy-related data (or metadata) from at least one lED at an electrically connected point higher within the electrical system (e.g., electrically connected to the at least one load diagnostic system and/or electrically closer to the electrical system's energy source). The method includes evaluating the collected data from the at least one load diagnostic system against the collected data from the at least one lED to identify at least one of relevant characteristic(s), commonality(s), trend(s), and issue(s) between the collected data from the at least one load diagnostic system and the collected data from the at least one lED. In addition, the method includes evaluating the identified at least one of similar characteristic(s), commonality(s), trend(s), and issue(s) to determine at least one of an electrical system characteristic, commonality, trend, and issue associated with the at least one lED and taking at least one action to address the at least one of an electrical system characteristic, commonality, trend, and issue associated with the at least one lED. The loads include, for example, at least one motor, relay, transformer, and/or capacitor bank. The energy-related data includes, for example, at least one energy-related measurement (e.g., PQ, WFCs, data logs, alarms, etc.), I/O condition/status, trend, or other statistical derivation and the non-energy-related data includes, for example, at least one equipment characteristic, metadata information (e.g., segment, nameplate data, load types, etc.), operational characteristics, or external condition. It should be noted that commonality(s) includes all types of patterns, co-occurrences, and their respective analysis(es). For example, commonality analysis may be trying to determine if the lED and CBM systems always identify a particular systemic issues. Alternatively, does the CBM system only detect partial co-occurrences that may be indicative of multiple loads under the same lED where only one is being monitored by a CBM.

Aspects of the present disclosure optionally use one or more digital or analog I/O signals to more optimally function. For example, one or more embodiments optionally use a digital status input signal from at least one single-phase or three-phase load (e.g., a polyphase induction motor) to simplify processing and/or enhancing its analysis(es), assessment(s), result(s) and/or recommendation(s). Alternatively, one or more embodiments may use an analog I/O signal from a load(s) (e.g., a polyphase induction motor) to incorporate measured temperatures (i.e., from thermocouple(s)) into its analysis(es), assessment(s), result(s), and/or recommendation(s). I/O signals may be produced or used by at least one of the lEDs, gateways, software systems, cloud-based systems or other applications as necessary.

It is to be understood that an input is data that a processor and/or lED receives, and an output is data that a processor and/or lED sends. Inputs and outputs may either be digital or analog. The digital and analog signals may be both discrete variables (e.g., two states such as high/low, one/zero, on/off, etc. If digital, this may be a value. If analog, the presence of a voltage/current may be considered by the system/IED as an equivalent signal) or continuous variables (e.g., continuously variable such as spatial position, temperature, pressure voltage, etc.). They may be digital signals (e.g., measurements in an lED coming from a sensor producing digital information/values) and/or analog signals (e.g., measurements in an lED coming from a sensor producing analog information/values). These digital and/or analog signals may include any processing step within the lED (e.g., derive an active power (kW), power factor, a magnitude, a relative phase angle, among all the derived calculations).

Processors and/or lEDs may convert/reconvert digital and analog input signals to a digital representation for internal processing. Processors and/or lEDs may also be used to convert/reconvert internally processed digital signals to digital and/or analog output signals to provide some indication, action, or other response (such as an input for another processor/IED). Typical uses of digital outputs may include signaling relays to open or close breakers or switches, signaling relays to start or stop motors and/or other equipment, and operating other devices and equipment that are able to directly interface with digital signals. Digital inputs are often used to determine the operational status/position of equipment (e.g., is a breaker open or closed, etc.) or read an input synchronous signal from a utility pulsed output. Analog outputs may be used to provide variable control of valves, motors, heaters, or other loads/processes in energy management systems. Finally, analog inputs may be used to gather variable operational data and/or in proportional control schemes.

A few more examples where digital and analog I/O data are leveraged may include (but not be limited to): turbine controls, plating equipment, fermenting equipment, chemical processing equipment, telecommunications, equipment, precision scaling equipment, elevators and moving sidewalks, compression equipment, waste water treatment equipment, sorting and handling equipment, plating equipment temperature/pressure data logging, electrical generation/transmission/distribution, robotics, alarm monitoring and control equipment, as a few examples.

The above-discussed method (and/or other systems and/or methods discussed herein) may include one or more of the following features either individually or in combination with other features in some embodiments. For example, in some embodiments the energy-related signals captured by the at least one lED may include at least one of: a voltage signal, a current signal, an input/output (I/O) data, and a derived energy-related value. In some embodiments, the I/O data includes at least one of on/off status(es), open/closed status(es), high/low status(es), temperature(s), pressure(s), and volume(s). Additionally, in some embodiments the derived energy-related value includes at least one of: a calculated, computed, estimated, derived, developed, interpolated, extrapolated, evaluated, and otherwise determined additional energy-related value from the at least one of the voltage signal and/or the current signal. In some embodiments, the derived energy-related value includes at least one of: active power, apparent power, reactive power, energy, harmonic distortion, power factor, magnitude/direction of harmonic power(s), harmonic voltage(s), harmonic current(s), interharmonic current(s), interharmonic voltage(s), magnitude/direction of interharmonic power(s), magnitude/direction of sub-harmonic power(s), individual phase currents, phase angle(s), impedance(s), sequence component(s), total voltage harmonic distortion, total current harmonic distortion, three-phase current(s), phase voltage(s), line voltage(s) and/or other similar/related parameters. In some embodiments, the derived energy-related value includes at least one energy-related characteristic, the energy-related characteristic including magnitude, direction, phase angle, percentage, ratio, level, duration, associated frequency components, impedance, energy-related parameter shape, and/or decay rate. It is understood that the energy-related signals may include (or leverage) substantially any electrical parameter derived from at least one of the voltage and current signals (including the voltages and currents themselves), including, for example, load levels and patterns, as will be understood from further discussions below.

In some embodiments, the above-discussed method (and/or other system(s) and/or method(s) discussed herein) may be implemented on the at least one lED called for in the above-discussed method (and/or other systems and/or methods discussed herein). Additionally, in some embodiments the above-discussed method (and/or other systems and/or methods discussed herein) may be implemented partially or fully remote from the at least one IED, for example, in a gateway, on-site software, edge software, a remote server, etc. (which may collectively or alternatively be referred to herein as a "head-end" system). It is to be understood that "cloud-based software," "edge software," "edge system," "management system," "software management system," etc. may collectively or alternatively be referred to herein as "head-end software" generally (for the purposes of this application). In some embodiments, the at least one lED may be coupled to measure energy-related signals, receive electrical measurement data from or derived from the energy-related signals at an input, and configured to generate at least one or more outputs. The outputs may be used to identify the at least one potential load type associated with the characterized and/or quantified at least one identified variation/change in the electrical system. Examples of the at least one lED may include a smart utility meter, a power quality meter, and/or another measurement device (or devices). The at least one lED may include breakers, relays, power quality correction devices, uninterruptible power supplies (UPSs), filters, and/or variable speed drives (VSDs), for example. Additionally, the at least one lED may include at least one virtual (e.g., residual energy-related signal measurement) meter in some embodiments.

In some embodiments, the energy-related signals may be continuously or semi-continuously captured and/or logged by the at least one IED, and variation(s)/change(s) identified in the energy-related signals may be updated (e.g., evaluated/re-evaluated, prioritized/re-prioritized, tracked, etc.) in response thereto. For example, variation(s)/change(s) may initially be identified from energy-related signals captured at a first time, and may be updated or revised in response to (e.g., to include or incorporate) variation(s)/change(s) identified from energy-related signals captured at a second time. As variation(s)/change(s) are identified, the variation(s)/change(s) may be characterized and/or quantified, information related to the characterized and/or quantified identified variation(s)/change(s) may be appended to time-series information associated with energy-related data, and characteristics and/or quantities associated with the time-series information may be evaluated to identify at least one potential load type associated with the characterized and/or quantified identified variation(s)/change(s), for example. The appended information may include, for example, tagged indications on the time-series information, metadata, characteristics and/or other information related to the characterized and/or quantified identified variation(s)/change(s). This may be performed by leveraging statistics based on time-series (e.g., local min, max, mean or median, coupled with variance such as standard deviation and interquartile ranges) or more advance algorithms and solutions such as "change point detection," "model changes detections," etc. to specify a few approaches among many possible candidates algorithms, tools and techniques.

As used herein, the terms "up-line" and "down-line" (also sometimes referred to as "upstream" and "downstream ", respectively) are used to refer to electrical locations within an electrical system. More particularly, the electrical locations "up-line" and "down-line" are relative to an electrical location of an lED collecting data and providing this information. For example, in an electrical system including a plurality of lEDs, one or more lEDs may be positioned (or installed) at an electrical location that is up-line relative to one or more other lEDs in the electrical system, and the one or more lEDs may be positioned (or installed) at an electrical location that is down-line relative to one or more further lEDs in the electrical system. A first lED or load that is positioned on an electrical circuit up-line from a second lED or load may, for example, be positioned electrically closer to an input or source of the electrical system (e.g., an electrical generator or a utility feed) than the second lED or load. Conversely, a first lED or load that is positioned on an electrical circuit down-line from a second lED or load may be positioned electrically closer to an end or terminus of the electrical system than the other lED (so in this case, it will be closer to a load or group of loads).

A first lED or load that is electrically connected in parallel (e.g., on an electrical circuit) with a second lED or load may be considered to be "electrically" up-line from said second lED or load in embodiments, and vice versa. In embodiments, algorithm(s) used for determining a direction of a power quality event (i.e., up-line or down-line) is/are located (or stored) in the IED, cloud, on-site software, gateway, etc. As one example, the lED can record an electrical event's voltage and current phase information (e.g., by sampling the respective signals) and communicatively transmit this information to a cloud-based system. The cloud-based system may then analyze the voltage and current phase information (e.g., instantaneous, root-mean-square (rms), waveforms and/or other electrical characteristic) to determine if the source/origin of an energy-related transient (or other energy-related event) is electrically up-line or down-line from where the lED is electrically coupled to the electrical system (or network).

In some embodiments, the energy-related data from or derived from the energy-related signals captured by the at least one lED is processed on at least one of: the IED, the cloud-based system, the on-site or edge software, the gateway, and any other head-end system associated with the electrical system. In these embodiments, for example, the at least one lED may be communicatively coupled to the at least one of: the cloud-based system, the on-site or edge software, the gateway, and any other head-end system on which the electrical measurement data is processed, analyzed, and/or displayed.

In some embodiments, data associated with the energy-related data is stored (e.g., in a memory device of at least one device or system associated with the electrical system) and/or tracked over a predetermined time period. The predetermined time period may be a user-configured time period, for example. In some embodiments, the stored and/or tracked data includes information associated with identifying the at least one potential load type. The information associated with identifying the at least one potential load type may include, for example, at least one of: the at least one identified variation/change, the characterized and/or quantified at least one identified variation/change, the time-series information, and the evaluated characteristics and/or quantities associated with the time-series information. In some embodiments, the information associated with identifying the at least one potential load type may be saved and/or tracked for future analyses/uses. For example, the stored and/or tracked information may be used to generate a library of load types and associated start/run/change/stop characteristics and/or be added to a pre-existing library of load types and associated start/run/change/stop characteristics. In embodiments in which there is a pre-existing library of load types and associated start/run/change/stop characteristics, the at least one potential load type identified using the systems and methods described herein may be selected from a plurality of potential loads types in the pre-existing library of load types and associated start/run/change/stop characteristics.

In some embodiments, the above-described system may correspond to a control system (e.g., the previously discussed control system) used for monitoring or controlling one or more parameters associated with the electrical system. As previously discussed, in some embodiments, the control system may be a meter, an lED (e.g., of the at least one lED responsible for capturing the energy-related signals), programmable logic controller (PLC), head-end software (i.e., a software system), a cloud-based control system, a gateway, a system in which data is routed over the Ethernet or some other communications system, etc.

It is understood that the systems and methods described herein may be responsive to changes in the electrical system(s) in which the systems and methods are provided and/or implemented. For example, the prescribed threshold or thresholds that the at least one identified variation/change is compared to determine if the at least one identified variation/change meets the prescribed threshold or thresholds, may be a dynamic threshold or thresholds that change in response to changes in the electrical system(s). The changes in the electrical system(s) may be detected, for example, from the energy-related signals captured by the at least one lED in the electrical system(s). In one example implementation, the changes are detected after manually training/teaching a system to identify the changes. For example, the specific equipment (or processes) operating at a given time may be described to allow the system to learn (i.e., a form of machine learning). In another example implementation, the changes are detected by automatically identifying operational modes using state of the art machine learning algorithms (e.g., using time series clustering or using spectral or any other algorithms helpful in analysis to identify patterns).

As will become further appreciated from discussions below, the disclosed invention provides, among other features, the ability to characterize voltage, current, and other derived signals to better understand upstream and downstream loads, their operation(s) and impact(s) to the electrical system. The ability to automatically evaluate energy-related data to associate, characterize, quantify, identify, and analyze helps end-users (e.g., facility managers, maintenance personnel, energy managers, etc.) to better understand the operation of their electrical system. It may also provide many more services and solutions opportunities to energy-related companies, such as Schneider Electric, the assignee of the present disclosure.

It is understood that the at least one energy-related waveform capture described in connection with the above method (and the other methods and systems discussed below) may be associated with energy-related signals captured or measured by the at least one lED. For example, in accordance with some embodiments of this disclosure, the at least one energy-related waveform capture may be generated from at least one energy-related signal captured or measured by the at least one lED. According to IEEE Standard 1057-2017, for example, a waveform is "[a] manifestation or representation (e.g., graph, plot, oscilloscope presentation, discrete time series, equations, table of coordinates, or statistical data) or a visualization of a signal." With this definition in mind, the at least one energy-related waveform may correspond to a manifestation or representation or a visualization of the at least one energy-related signal. It is understood that the above relationship is based on one standards body's (IEEE in this case) definition of a waveform, and other relationships between a waveform and a signal are of course possible, as will be understood by one of ordinary skill in the art.

It is understood that the energy-related signals or waveforms captured or measured by the at least one lED may include (or leverage) substantially any electrical parameter derived from at least one of the voltage and current signals (including the voltages and currents themselves), for example. It is also understood that the energy-related signals or waveforms may be continuously or semi-continuously/periodically captured/recorded and/or transmitted and/or logged by the at least one lED. As noted above, the at least one captured energy-related waveform may be analyzed (e.g., in real-time, pseudo-real time, or historically) to determine if the at least one captured energy-related waveform is capable of being compressed, while maintaining relevant attributes for characterization, analysis and/or other use.

In some embodiments, the at least one lED capturing the energy-related waveforms includes at least one metering device. The at least one metering device may correspond, for example, to at least one metering device in the electrical system for which the energy-related waveforms are being captured/monitored.

It is understood that the terms "processor" and "controller" are sometimes used interchangeably herein. For example, a processor may be used to describe a controller. Additionally, a controller may be used to describe a processor.

Embodiments of the present disclosure may comprise a special purpose computer including a variety of computer hardware, as described in greater detail herein.

For purposes of illustration, programs and other executable program components may be shown as discrete blocks. It is recognized, however, that such programs and components reside at various times in different storage components of a computing device, and are executed by a data processor(s) of the device.

Although described in connection with an example computing system environment, embodiments of the aspects of the invention are operational with other special purpose computing system environments or configurations. The computing system environment is not intended to suggest any limitation as to the scope of use or functionality of any aspect of the invention. Moreover, the computing system environment should not be interpreted as having any dependency or requirement relating to any one or combination of components illustrated in the example operating environment. Examples of computing systems, environments, and/or configurations that may be suitable for use with aspects of the invention include, but are not limited to, personal computers, server computers, hand-held or laptop devices, multiprocessor systems, microprocessor-based systems, set top boxes, programmable consumer electronics, mobile telephones, network PCs, minicomputers, mainframe computers, distributed computing environments that include any of the above systems or devices, and the like.

Embodiments of the aspects of the present disclosure may be described in the general context of data and/or processor-executable instructions, such as program modules, stored one or more tangible, non-transitory storage media and executed by one or more processors or other devices. Generally, program modules include, but are not limited to, routines, programs, objects, components, and data structures that perform particular tasks or implement particular abstract data types. Aspects of the present disclosure may also be practiced in distributed computing environments where tasks are performed by remote processing devices that are linked through a communications network. In a distributed computing environment, program modules may be located in both local and remote storage media including memory storage devices.

In operation, processors, computers and/or servers may execute the processor-executable instructions (e.g., software, firmware, and/or hardware) such as those illustrated herein to implement aspects of the invention.

Embodiments may be implemented with processor-executable instructions. The processor-executable instructions may be organized into one or more processor-executable components or modules on a tangible processor readable storage medium. Also, embodiments may be implemented with any number and organization of such components or modules. For example, aspects of the present disclosure are not limited to the specific processor-executable instructions or the specific components or modules illustrated in the figures and described herein. Other embodiments may include different processor-executable instructions or components having more or less functionality than illustrated and described herein.

The order of execution or performance of the operations in accordance with aspects of the present disclosure illustrated and described herein is not essential, unless otherwise specified. That is, the operations may be performed in any order, unless otherwise specified, and embodiments may include additional or fewer operations than those disclosed herein. For example, it is contemplated that executing or performing a particular operation before, contemporaneously with, or after another operation is within the scope of the invention.

When introducing elements of the invention or embodiments thereof, the articles "a," "an," "the," and "said" are intended to mean that there are one or more of the elements. The terms "comprising," "including," and "having" are intended to be inclusive and mean that there may be additional elements other than the listed elements.

Not all of the depicted components illustrated or described may be required. In addition, some implementations and embodiments may include additional components. Variations in the arrangement and type of the components may be made without departing from the spirit or scope of the claims as set forth herein. Additional, different or fewer components may be provided and components may be combined. Alternatively, or in addition, a component may be implemented by several components.

The above description illustrates embodiments by way of example and not by way of limitation. This description enables one skilled in the art to make and use aspects of the invention, and describes several embodiments, adaptations, variations, alternatives and uses of the aspects of the invention, including what is presently believed to be the best mode of carrying out the aspects of the invention. Additionally, it is to be understood that the aspects of the invention are not limited in its application to the details of construction and the arrangement of components set forth in the following description or illustrated in the drawings. The aspects of the invention are capable of other embodiments and of being practiced or carried out in various ways. Also, it will be understood that the phraseology and terminology used herein is for the purpose of description and should not be regarded as limiting.

It will be apparent that modifications and variations are possible without departing from the scope of the invention defined in the appended claims. As various changes could be made in the above constructions and methods without departing from the scope of the invention, it is intended that all matter contained in the above description and shown in the accompanying drawings shall be interpreted as illustrative and not in a limiting sense.

In view of the above, it will be seen that several advantages of the aspects of the invention are achieved and other advantageous results attained.

Accordingly, the present invention may be described as follows, optionally in combination with one or more of the above-mentioned features of the present invention: A causal diagnostic system and method for monitoring and predicting issues associated in an electrical system. A load diagnostic system coupled to a load within the electrical system acquires first data relating to the load and an lED connected within the electrical system nearer an electrical source upstream of the monitored load. The lED acquires second data relating to the electrical system, which is at least one of energy-related data and non-energy-related data. A processor receiving and responsive to the acquired first and second data executes instructions for evaluating the first data against the second data to identify a correlation therebetween, evaluating the identified correlation to determine a condition of the electrical system associated with the IED, and taking at least one action to address the condition of the electrical system associated with the lED.

## Claims

1. Method for monitoring and predicting issues associated in an electrical system, the method comprising:
acquiring, by at least one load diagnostic system, first data relating to a load within the electrical system monitored by the at least one load diagnostic system;
acquiring, by at least one intelligent electronic device (IED), second data relating to the electrical system, the second data comprising at least one of energy-related data and non-energy-related data, the at least one lED electrically connected within the electrical system nearer an electrical source thereof upstream of the load monitored by the at least one load diagnostic system;
evaluating the first data acquired by the at least one load diagnostic system against the second data acquired by the at least one lED to identify a correlation therebetween;
evaluating the identified correlation to determine a condition of the electrical system associated with the at least one IED; and
taking at least one action to address the condition of the electrical system associated with the at least one lED.

2. Method as set forth in claim 1, wherein the first data relating to the load comprises at least one of energy-related data and non-energy-related data, and optionally wherein the non-energy-related data relating to the load includes one or more of an equipment characteristic, metadata information, an operational characteristic, and an external condition.

3. Method as set forth in claim 1 or claim 2, wherein the correlation comprises one or more of a relevant characteristic, a commonality, a trend, and an issue between the first data acquired by the at least one load diagnostic system and the second data acquired by the at least one lED.

4. Method as set forth in any one of claims 1 to 3, wherein the load comprises at least one of a motor, a relay, a transformer, and a capacitor bank.

5. Method as set forth in any one of claims 1 to 4, wherein the at least one load diagnostic system comprises a condition-based monitoring (CBM) system coupled to the load, and further comprising:
evaluating, by the CBM system, one or more parameters associated with operation of the load; and
learning a baseline operation of the load for use in identifying a deviation therefrom, wherein the deviation from the baseline operation of the load is indicative of a condition of the load.

6. Method as set forth in claim 5, wherein learning the baseline operation of the load comprises adjusting the baseline operation of the load as a function of the second data acquired by the at least one lED.

7. Method as set forth in any one of claims 1 to 6, wherein acquiring the first data comprises aggregating the first data acquired by a plurality of load diagnostic systems, the aggregated first data relating to a plurality of loads within the electrical system each monitored by one of the plurality of load diagnostic systems.

8. Causal diagnostic system for monitoring and predicting issues associated in an electrical system, the causal diagnostic system comprising:
at least one load diagnostic system coupled to a load within the electrical system, the at least one load diagnostic system acquiring first data relating to the load monitored thereby;
at least one intelligent electronic device (IED) connected within the electrical system nearer an electrical source thereof upstream of the load monitored by the at least one load diagnostic system, the at least one lED acquiring second data relating to the electrical system, the second data comprising at least one of energy-related data and non-energy-related data;
at least one processor receiving and responsive to the acquired first and second data; and
at least one memory device coupled to the at least one processor, the at least one memory device storing processor-executable instructions that, when executed, configure the at least one processor for:
evaluating the first data acquired by the at least one load diagnostic system against the second data acquired by the at least one lED to identify a correlation therebetween;
evaluating the identified correlation to determine a condition of the electrical system associated with the at least one IED; and
taking at least one action to address the condition of the electrical system associated with the at least one lED.

9. Causal diagnostic system as set forth in claim 8, wherein the first data relating to the load comprises at least one of energy-related data and non-energy-related data; and optionally wherein the non-energy-related data relating to the load includes one or more of an equipment characteristic, metadata information, an operational characteristic, and an external condition.

10. Causal diagnostic system as set forth in claim 8 or claim 9, wherein the correlation comprises one or more of a relevant characteristic, a commonality, a trend, and an issue between the first data acquired by the at least one load diagnostic system and the second data acquired by the at least one lED.

11. Causal diagnostic system as set forth in any one of claims 8 to 10, wherein the load comprises at least one of a motor, a relay, a transformer, and a capacitor bank.

12. Causal diagnostic system as set forth in any one of claims 8 to 11, wherein the at least one load diagnostic system comprises a condition-based monitoring (CBM) system coupled to the load, and wherein the at least one memory device stores processor-executable instructions that, when executed, further configure the at least one processor for:
evaluating one or more parameters associated with operation of the load; and
learning a baseline operation of the load for use by the CBM system in identifying a deviation therefrom, wherein the deviation from the baseline operation of the load is indicative of a condition of the load.

13. Causal diagnostic system as set forth in claim 12, wherein learning the baseline operation of the load comprises adjusting the baseline operation of the load as a function of the second data acquired by the at least one lED.

14. Causal diagnostic system as set forth in claim 12 or claim 13, wherein the at least one memory device stores processor-executable instructions that, when executed, further configure the at least one processor for taking at least one action to address the condition of the load.

15. Causal diagnostic system as set forth in any one of claims 8 to 14, wherein the at least one load diagnostic system comprises a plurality of load diagnostic systems coupled to a plurality of loads within the electrical system, and wherein the first data is aggregated from each of the plurality of load diagnostic systems and the aggregated first data relates to the plurality of loads within the electrical system each monitored by one of the plurality of load diagnostic systems.
